Europäisches Patentamt

European Patent Office

Office européen des brevets

(11) Publication number: **0 365 634 B1**

(12) **EUROPEAN PATENT SPECIFICATION**

(45) Date of publication of patent specification: **20.10.93**

(51) Int. Cl.5: **H03M 13/00**, G11B 20/18, G06F 11/10

(21) Application number: **89904394.7**

(22) Date of filing: **14.03.89**

(86) International application number:
**PCT/US89/01050**

(87) International publication number:
**WO 89/10029 (19.10.89 89/25)**

(54) **METHOD AND APPARATUS FOR ENCODING CONSISTING OF FORMING A CODEWORD BY COMBINING A FIRST CODE SEOUENCE WITH A SECOND CODE SEOUENCE.**

(30) Priority: **08.04.88 US 179646**

(43) Date of publication of application:
**02.05.90 Bulletin 90/18**

(45) Publication of the grant of the patent:
**20.10.93 Bulletin 93/42**

(84) Designated Contracting States:
**DE FR GB IT NL**

(56) References cited:
**EP-A- 0 205 667**
**WO-A-83/01334**
**US-A- 3 638 182**
**US-A- 4 413 340**
**US-A- 4 598 403**

(73) Proprietor: **DIGITAL EOUIPMENT CORPORA-TION**
**111 Powdermill Road**
**Maynard Massachusetts 01754-1418(US)**

(72) Inventor: **WENG, Lih-Jyh**
**6 Bicentennial Drive**
**Lexington, MA 02173(US)**

(74) Representative: **Goodman, Christopher et al**
**Eric Potter & Clarkson**
**St. Mary's Court**
**St. Mary's Gate**
**Nottingham NG1 1LE (GB)**

EP 0 365 634 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services
(3.10/3.6/3.3.1)

**Description**

Background of the Invention

This invention relates to method for encoding information and for locating, reading, and writing information stored on a disk.

In systems that store data on sectors of a magnetic disk, the stored header that identifies each sector may be encoded to reduce the effect of bit errors that occur in recording. The header typically includes an address that uniquely identifies the sector and may include additional information, such as a bad sector flag and a servo correction number. To locate a particular sector on a specified track of the disk and to read or write data in that sector, the header of each sector along that track must be read and analyzed quickly.

To determine if a sector is the one being sought the sector address on the disk is read and compared with the specified address of the desired sector in which data is to be read or written. If the addresses match, the data will be read from or written to the sector.

If a sector address read from the disk has errors, the sector may be mistakenly identified, causing the disk drive to incorrectly determine, for example, that the head is located over sector 100 when it is actually located over sector 101. As a result, the read or write operation that is to occur at sector 100 will be performed on the wrong sector. If a sector address contains several errors or the address is corrupted due to a medium defect or soft error in the disk, the sector address may be unreadable making the sector unusable.

To avoid misinterpreting the address of a sector, the sector addresses must be written on the disk in such a way that even with a number of errors in the address, it will neither be read as the address of a different sector nor be rendered unidentifiable.

In US-3638182 there is described an error-correcting arrangement in which transmitted codewords contain two kinds of data: an encoded version of a current value, and an encoded portion of a previously-transmitted value. When a codeword is received, if the number of errors exceeds a threshold value, the codeword is discarded, and the value is reconstructed from the portions which appear in subsequent codewords. In US-4598403 there is described an "interleaving" scheme in which multiple codes are overlapped to create more error-resilient codewords. In both of these references, information relating to the validity of the codeword is not available with full decoding of the codeword.

Summary of the Invention

The invention features a method and an apparatus as defined in Claims 1 and 25, respectively. It is suitable for quickly locating sectors on a magnetic disk, finding bad sectors on the disk, and centering a head on a track of the disk. The address of each sector is encoded as a first preliminary code sequence in accordance with a first code. A second preliminary code sequence is generated from bad sector information and servo control information about the location of the center of the track, in accordance with a second code. A code word is formed based on combining the first and second preliminary code sequences, and the codeword is recorded in the sector during formatting of the disk. The codeword, possibly corrupted, is read from each sector of the track rotating under the head. The first preliminary code sequence is stripped from the possibly corrupted codeword to derive a test sequence comprising a possibly corrupted version of the second preliminary code sequence. The test sequence is decoded in accordance with the second code to determine the number of errors in the corrupted codeword. The number of errors are compared to a threshold T. If the number of errors is no greater than T, the sector is accepted as the one being sought. Note that the sector address does not even need to be fully decoded; the information about the number of errors relative to T is sufficient to determine whether or not the desired sector has been reached. If decoded bad sector information indicates a bad sector, no write operation will be performed in that sector. The servo control information is used to control the position of the head.

Another application of the invention is encoding bad sector, servo correction, and sector address values for storage in a header associated with a sector of storage in a storage medium; the address value with leading zero symbols is encoded in accordance with a code of a first rate; the bad sector and servo correction values are encoded in a systematic code having a second rate; and the first and second preliminary code sequences are combined to generate a codeword of the first code such that the bad sector and servo correction values appear explicitly in the codeword but the sector address value does not appear explicitly in the codeword.

Another application of the invention encodes information in a codeword that may be subjected to no more than a predetermined degree of corruption, and then, without fully decoding a corrupted version of the codeword, determines from the corrupted codeword whether the information was used in encoding the codeword; the information is encoded as a first preliminary code sequence in accordance with the first code; the codeword is formed by combining the first preliminary code sequence with a second preliminary code sequence generated in accordance with a second code; the first preliminary code sequence is stripped from the corrupted version of the code word to derive a test sequence comprising a corrupted version of possibly the second preliminary code sequence; the test sequence is decoded in accordance with the second code; and determination is made based on the decoding whether the information was used in encoding the codeword.

Preferred embodiments of the invention include the following features.

The legitimate code sequences of the second code are a subset of the legitimate code sequences of the first code. The first code is not systematic with respect to the information. The first code is a cyclic error correcting (n,k) code, and the second code is a cyclic error correcting (n,m) code, where m is smaller than k. The second code is susceptible to being fully decoded by permutation decoding but the first code is not susceptible to being fully decoded by permutation decoding. The first and second codes are respectively (33,8) and (33,2) Reed-Solomon codes, each code symbol being 5 bits long.

The method may be further adapted for encoding additional information in the codeword such that, without fully decoding the corrupted version of the codeword, the additional information may be fully reconstructed from the corrupted codeword; the additional information is encoded in the second preliminary code sequence; and the additional information is then reconstructed based on the decoding of the test sequence series.

The information includes an address of a block (e.g., a sector of a magnetic disk) of data on a recording medium. The additional information includes a bad sector flag and a servo correction number.

The method further includes combining the codeword with a coset leader and removing the coset leader from the corrupted codeword prior to stripping off the first preliminary code sequence. The second code is systematic with respect to the additional information. The codeword is a string of n symbols, the high order m said symbols being the additional information. The first preliminary code sequence is a string of n symbols, the high order k said symbols comprising at least one zero symbol followed by the information.

The decoding includes permutation decoding over a field of finite elements having fewer elements than the field that would be required for fully decoding the corrupted codeword. The determination of whether the information was used in encoding the codeword includes detecting the distance between the test sequence and legitimate codeword. The distance is compared with a predetermined threshold value whose maxmimum is smaller than the error correcting capability of the second code and equal to the error correcting capability of the first code. The decoding of the test sequence includes encoding simultaneously in parallel, in accordance with the second code, all possible code sequences corresponding to each possible value of the additional information, and comparing simultaneously in parallel each possible code sequence with the test sequence.

The first and second codes are maximum distance separable codes, the first code having a smaller distance than the second code.

The invention enables rapid, accurate determination that the desired sector has been reached, while permitting quick reconstruction of the bsf and scn values. The decoding can be accomplished by simple permutation decoding even though the code in which the address information is encoded could not be fully decoded by permutation decoding. The decoding can proceed over a smaller field of elements than would be required for fully decoding the complete codeword. In cases where parallel decoding is used, it is relatively efficient and simple.

Other advantages and features will become apparent from the following description of the preferred embodiment and from the claims.

Description of the Preferred Embodiment

We first briefly describe the drawings.

Fig. 1 is a diagram of a sector on a track of a disk.

Fig. 2 is a diagram of codewords.

Fig. 3 is a flow chart of codeword generation.

Figs. 4, 5 are block diagrams of encoders.

Fig. 6 is a block diagram of an encoding and recording circuit.

Fig. 7 is a diagram of three codewords

Fig. 8 is a flowchart of codeword decoding.

Fig. 9 is a block diagram of a decoding and sector identification circuit.
Fig. 10 is a diagram of the distance properties of two codes.
Fig. 11 is a block diagram of a decoder.
Fig. 12 is a flow chart for decoding a codeword.
Fig. 13 is a block diagram of a parallel recursive decoder circuit.
Fig. 14 is a flow chart corresponding to Fig. 13.

Structure and Operation

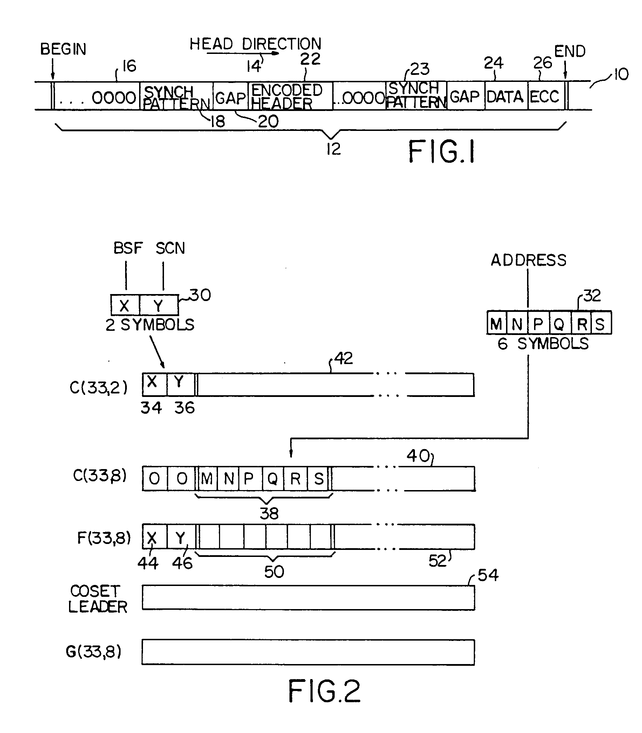

Referring to Fig. 1, each track 10 of a magnetic disk is divided into sectors on which bits are recorded. Each sector 12 includes a sequence of fields that are scanned in order by a read head moving in the direction indicated by arrow 14. The first field is a string of leading heroes 16 used by a phase locked loop in a disk controller (not shown) to synchronize the operation of the read head with the bit spacing along the track. The second field 18 is a synchronization pattern which indicates that the data will appear next on the track. A short gap 20 follows the synchronization pattern. Next comes the data itself, including an encoded header 22, a second synchronization pattern 23 (preceded by leading zeroes and followed by a gap), data 24 (e.g. user data), and error correction code bits 26 which apply to the data in field 24.

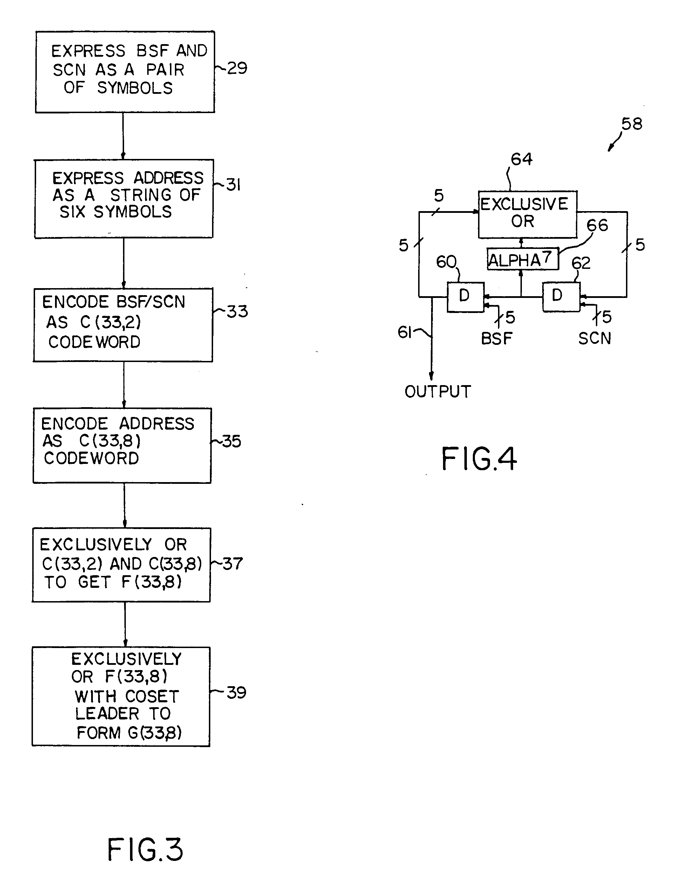

Referring to Figs. 2, 3, the encoded header for a given sector (which is prerecorded on the disk at the time of manufacture or formatting) is encoded using the address, bsf (bad sector flag), and scn (servo correction number) values that pertain to that sector by the following procedure.

First, the bsf and scn values are expressed (29) as a pair of 5-bit symbols 30 and the address is expressed (31, Fig. 3) as a string of six 5-bit symbols 32. Next, the bsf/scn symbol pair 30 is encoded (33) as a codeword C(33,2) in a Reed-Solomon maximum distance separable and cyclic (33,2) distance 32 code, (described below). By nature of the code used, the codeword C(33,2) has two leading symbols 34, 36 (identical to the bsf/scn symbol pair 30) followed by thirty-one 5-bit redundancy symbols 42.

Next, the six symbol address string 32 is encoded (35) as a (33,8) distance 26 Reed Solomon codeword, C(33,8). The code (described below) is arranged such that C(33,8) has two leading zero-valued symbols, followed by a six-symbol string 38 (identical to string 32) followed by twenty-five redundancy symbols 40.

Next, the preliminary code sequences C(33,2) and C(33,8) are exclusively ORed (37) to form a composite codeword F(33,8). F(33,8) comprises two leading symbols 44, 46 identical to the bsf/scn symbol pair, followed by six symbols 50 in which both redundancy and address information are imbedded (in this sense F(33,8) is not systematic). The remaining twenty-five symbols 52 are imbedded with redundancy information from both C(33,2) and C(33,8). F(33,8) is a codeword in the original (33,8) code because both C-(33,8) and C(33,2) are codewords in the (33,8) code. Note that the codes are designed so that every (33,2) codeword is in the (33,8) code.

Next, F(33,8) is exclusively ORed (39) with a thirty-three symbol coset leader 54 to form an adjusted final codeword G (33,8). The coset leader is chosen to reduce the chance of mistaken bit and/or symbol synchronization during decoding. One example of a good coset leader is

$$
\begin{aligned}
&\text{alpha}^0 * X^{24} \; (+) \; \text{alpha}^8 * X^{23} \; (+) \; \text{alpha}^{25} * X^{22} \\
&(+) \; \text{alpha}^3 * X^{21} \; (+) \; \text{alpha}^5 * X^{20} \; (+) \; \text{alpha}^9 * X^{19} \\
&(+) \; \text{alpha}^{20} * X^{18} \; (+) \; \text{alpha}^{10} * X^{17} (+) \; \text{alpha}^4 * X^{16} \\
&(+) \; \text{alpha}^{28} * X^{15} \; (+) \; \text{alpha}^9 * X^{14} \; (+) \; \text{alpha}^8 * X^{13} \\
&(+) \; \text{alpha}^8 * X^{12} \; (+) \; \text{alpha}^9 * X^{11} \; (+) \; \text{alpha}^{28} * X^{10} \\
&(+) \; \text{alpha}^4 * X^9 \; (+) \; \text{alpha}^{10} * X^8 \; (+) \; \text{alpha}^{20} * X^7 \\
&(+) \; \text{alpha}^9 * X^6 \; (+) \; \text{alpha}^5 * X^5 \; (+) \; \text{alpha}^3 * X^4 \\
&(+) \; \text{alpha}^{25} * X^3 \; (+) \; \text{alpha}^8 * X^2 \; (+) \; \text{alpha}^0 * X^1
\end{aligned}
$$

The coset leader has no terms for $X^{25}$ through $X^{32}$ and thus does not alter the high order eight symbols of F(33,8).

The (33,8) distance 26 code is a code over a Galois field $GF(2^5)$ generated by the primitive polynomial

4

$x^5 \,(+)\, x^4 \,(+)\, x^3 \,(+)\, x^2 \,(+)\, 1$

where $(+)$ denotes exclusive OR, and x denotes an indeterminate or variable. $GF(2^5)$ may be represented by the following 32 elements:

$0 = (00000)$, $alpha^0 = (00001)$, $alpha^1 = (00010)$ $alpha^2 = (00100)$, $alpha^3 = (01000)$, $alpha^4 = (10000)$, $alpha^5 = (11101)$, $alpha^6 = (00111)$, $alpha^7 = (01110)$, $alpha^8 = (11100)$, $alpha^9 = (00101)$, $alpha^{10} = (01010)$, $alpha^{11} = (10100)$, $alpha^{12} = (10101)$, $alpha^{13} = (10111)$, $alpha^{14} = (10011)$, $alpha^{15} = (11011)$, $alpha^{16} = (01011)$, $alpha^{17} = (10110)$, $alpha^{18} = (10001)$, $alpha^{19} = (11111)$, $alpha^{20} = (00011)$, $alpha^{21} = (00110)$, $alpha^{22} = (01100)$, $alpha^{23} = (11000)$, $alpha^{24} = (01101)$, $alpha^{25} = (11010)$, $alpha^{26} = (01001)$, $alpha^{27} = (10010)$, $alpha^{28} = (11001)$, $alpha^{29} = (01111)$, $alpha^{30} = (11110)$,

The codeword C(33,2) for any given bsf/scn symbol pair (denoted by a polynomial of degree 32 over the elements of $GF(2^5)$) may be generated from the elements of $GF(2^5)$ either by the following generator polynomial:

$$
\begin{aligned}
G2(X) = X^{31} &(+) \ alpha^7 * X^{30} (+) \ alpha^{27} * X^{29} \\
&(+) \ alpha^{21} * X^{28} \\
(+) \ alpha^{16} * X^{27} \quad &(+) \ alpha^{30} * X^{26} \\
&(+) \ alpha^{22} * X^{25} \\
(+) \ alpha^{18} * X^{24} \quad &(+) \ alpha^{17} * X^{23} \\
&(+) \ alpha^{8} * X^{22} \\
(+) \ alpha^{24} * X^{21} \quad &(+) \ alpha^{5} * X^{20} \\
&(+) \ alpha^{23} * X^{19} \\
(+) \ alpha^{20} * X^{18} \quad &(+) \ alpha^{10} * X^{17} \\
&(+) \ alpha^{12} * X^{16} \\
(+) \ alpha^{12} * X^{15} \quad &(+) \ alpha^{10} * X^{14} \\
&(+) \ alpha^{20} * X^{13} \\
(+) \ alpha^{23} * X^{12} \quad &(+) \ alpha^{5} * X^{11} \\
&(+) \ alpha^{24} * X^{10} \\
(+) \ alpha^{8} * X^{9} \quad &(+) \ alpha^{17} * X^{8} \\
&(+) \ alpha^{18} * X^{7} \\
(+) \ alpha^{22} * X^{6} \quad &(+) \ alpha^{30} * X^{5} \\
&(+) \ alpha^{16} * X^{4} \\
(+) \ alpha^{21} * X^{3} \quad &(+) \ alpha^{27} * X^{2} \\
(+) \ alpha^{7} * X \quad &(+) \ 1
\end{aligned}
$$

(where * means multiplication) or by the following recursive polynomial:

$H2(X) = X^2 (+) (alpha^7)^* (X) (+) 1.$

In this case, the recursive polynomial is easier to implement, as follows. Referring to Fig. 4, in encoder 58, the bsf and scn symbols are initially entered respectively in a pair of one-symbol-interval delay elements 60, 62. The output 61 of delay element 60 is a stream of symbols making up C(33,2), with the highest order symbol in the codeword appearing first. The output of delay element 60 is also fed to an exclusive OR element 64, whose second input is the $alpha^7$ element of $GF(2^5)$ multiplied by the output of delay element 62. In Fig. 4, the block $alpha^7$ (labeled 66) performs the multiplication. The output of element 64 is in turn fed back to delay element 62. Encoder 58 is cycled 33 times to generate the 33 symbols of the codeword.

The codeword C(33,8) for any given header address similarly may be generated either by the following generator polynomial:

$$G8(X) = X^{25} (+) \text{ alpha}^{18}*X^{24}(+) \text{ alpha}^{28}*X^{23}(+) \text{ alpha}^{9}*X^{22}$$

$$(+) \text{ alpha}^{12}*X^{21}(+) \text{ alpha}^{1}*X^{20}(+) \text{ alpha}^{25}*X^{19}$$

$$(+) \text{ alpha}^{23}*X^{18}(+) \text{ alpha}^{15}*X^{17}(+) \text{ alpha}^{10}*X^{16}$$

$$(+) \text{ alpha}^{14}*X^{15}(+) \text{ alpha}^{0}*X^{14}(+) \text{ alpha}^{15}*X^{13}$$

$$(+) \text{ alpha}^{15}*X^{12}(+) \text{ alpha}^{0}*X^{11}(+) \text{ alpha}^{14}*X^{10}$$

$$(+) \text{ alpha}^{10}*X^{9}(+) \text{ alpha}^{15}*X^{8}(+) \text{ alpha}^{23}*X^{7}$$

$$(+) \text{ alpha}^{25}*X^{6}(+) \text{ alpha}^{1}*X^{5}(+) \text{ alpha}^{12}*X^{4}$$

$$(+) \text{ alpha}^{9}*X^{3}(+) \text{ alpha}^{28}*X^{2}(+) \text{ alpha}^{18}*X (+) 1$$

or by the corresponding recursive polynomial:

$$H8(X) = X^{8}(+) \text{ alpha}^{18}*X^{7}(+) \text{ alpha}^{2}*X^{6}(+) \text{ alpha}^{5}*X^{5}$$

$$(+) \text{ alpha}^{0}*X^{4}(+) \text{ alpha}^{5}*X^{3}(+) \text{ alpha}^{2}*X^{2}$$

$$(+) \text{ alpha}^{18}*X (+) 1.$$

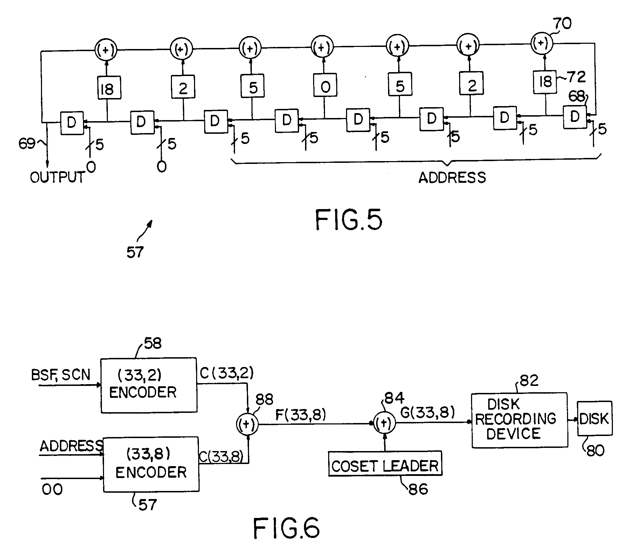

The encoder for C(33,8) may be configured either as an 8-stage linear shift register connected according to the recursive polynomial or a 25-stage linear shift register connected according to the generator polynomial. In the former case, referring to Fig. 5, the encoder 57 would include eight delay elements 68 , eight exclusive OR elements 70, and eight multiply-by-alpha elements 72 (the number in each block 72 identifies the alpha value). Initially two leading zeroes and the six address symbols are loaded into the delay elements, the encoder is cycled 33 times, and the output 69 is C (33,8) beginning with the two high order zero symbols.

In summary, referring to Fig. 6, during manufacture a disk 80 is prerecorded by disk recording device 82 with headers that define the sectors of the disk. Each header is a word G(33,8) generated from an exclusive OR element 84 in which F(33,8) and a coset leader 86 are combined. F(33,8) is generated in exclusive OR element 88 from C(33,2) and C(33,8) which are derived from encoders 57, 58.

In use, each time the disk is to be accessed at a specific sector of a particular track, the headers of the successive sectors of the track are read and analyzed to find the desired sector. Each header address read from the disk need not be fully decoded, but merely analyzed sufficiently to be certain that it could be accurately and fully decoded to give the desired address. So long as the number of symbol errors is no greater than T, it is certain that the present sector is the desired one.

On the other hand, the bsf/scn symbols must be fully decoded in order to determine if the sector is good and to control the position of the head relative to the center line of the track. The bsf information may be used, for example, during a write operation, to avoid writing in a bad sector.

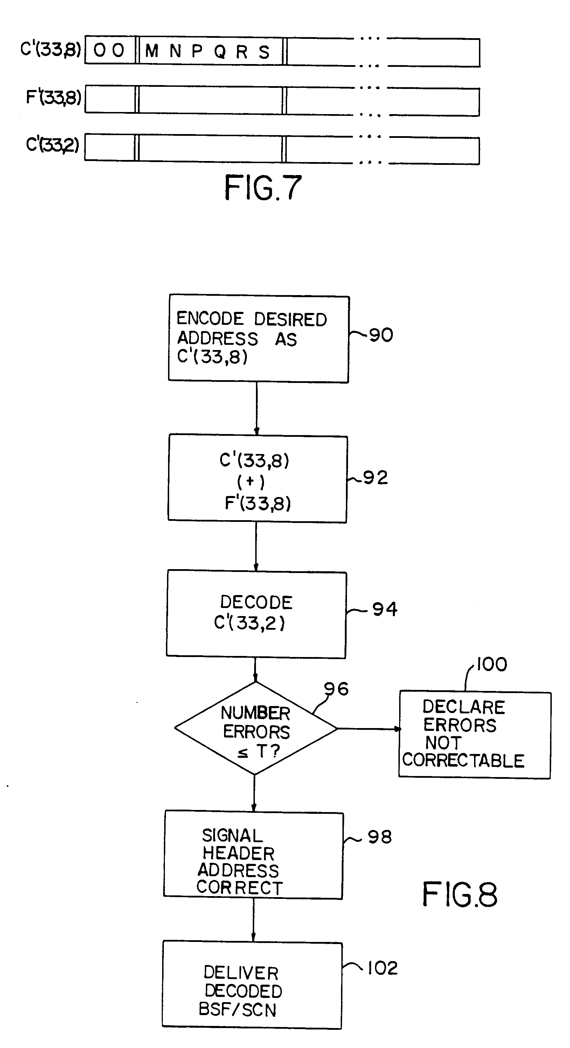

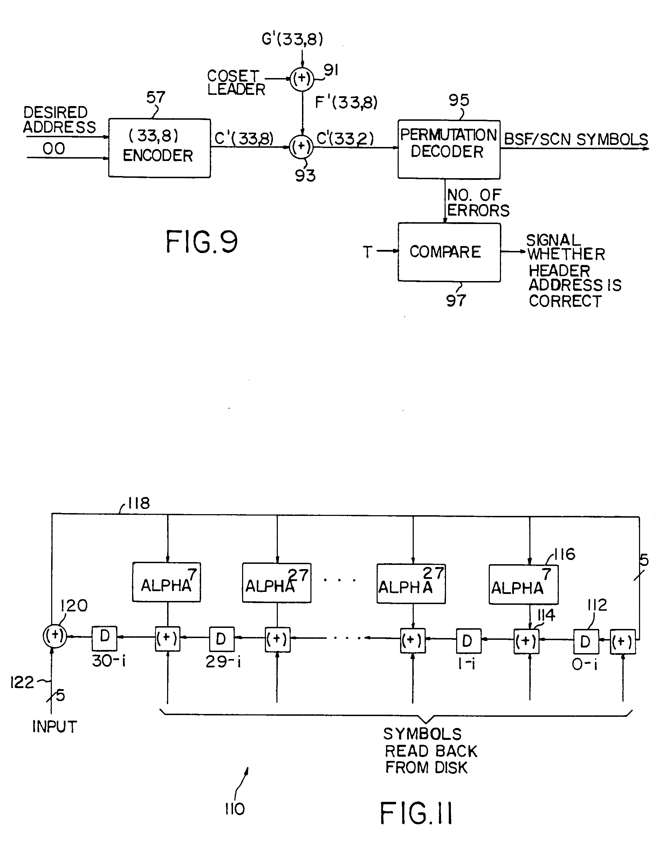

Referring to Figs. 7, 8, 9, the first step in decoding is to generate (90) a prototype codeword C'(33,8) based on the six-symbol desired address, e.g., MNPQRS, using the same kind of encoder 57 as for encoding. Note that if there were no recording errors, C'(33,8) would equal C(33,8) for the sector being sought.

The next step is to exclusively OR (92) C'(33,8) with F'(33,8), the version of F(33,8) derived by reading the encoded header address G'(33,8) recorded on the disk. This is done in exclusive OR element 93. F'-(33,8) is derived from G'(33,8) simply by exclusively ORing it with the original coset leader in exclusive OR element 91. Note that F'(33,8) will be a corrupted version of F(33,8) for example because of bit errors which may have occurred during reading of G(33,8) on the disk.

The exclusive OR step (92) strips from F'(33,8) the information contained in C'(33,8) and leaves a possibly corrupted version C'(33,2) of the original codeword C(33,2).

The next step is to decode (94) C'(33,2) over GF($2^5$) in permutation decoder 95 to generate a value equal to the number of symbol errors in the header (as described below).

Finally, the number of errors is compared (96) with a threshhold T in a comparator 97. If the number of errors is no greater than T, the decoder signals that the header address is the one being sought (98) and the fully decoded values bsf and scn are delivered (102) to the disk controller. Otherwise the decoder signals (100) that the number of errors is too great for proper decoding, indicating either that the desired sector has not been reached or that the number of errors in the header of the desired sector is too great to be corrected.

This procedure works for the following reason.

Suppose that F'(33,8) = F(33,8), that is the retrieved codeword is uncorrupted relative to the originally generated codeword. Assume also that C'(33,8) = C(33,8), that is the current header address is the one being sought. Then stripping C'(33,8) from F'(33,8) will produce a C'(33,2) which is precisely the same as C(33,2). Decoding C'(33,2) will result in no symbol errors to be corrected, indicating that the desired sector has been found, and the first two symbols will be the bsf/scn symbol pair.

On the other hand, if C'(33,8) differs from C(33,8), (that is the current header address is not the one being sought) then C'(33,2) will not be a legitimate codeword of the (33,2) code but will be a legitimate codeword of the (33,8) code and thus will have a distance of at least 26 from any legitimate (33,2) codeword (because the (33,8) code has distance 26 and we know C'(33,2) is not a (33,2) codeword). That C'(33,2) is a (33,8) codeword is apparent from the fact that

C'(33,2) = C'(33,8) (+) C(33,8) (+) C(33,2)

because all three codewords C'(33,8), C(33,8) and C(33,2) are in the (33,8) code. Only under special conditions would C'(33,2) be a (33,2) codeword.

More generally, where F'(33,8) is not the same as F(33,8), if C'(33,2) is no farther than some number T symbols from a legitimate codeword C(33,2), then C'(33,2) may be presumed to be a corrupted version of a legitimate (33,2) codeword, thus implying that the header address used to derive C'(33,2) from F'(33,8) was the same one used to generate F(33,8) in the first place. Otherwise, the codeword C'(33,2) would not be a corrupted version of a legitimate codeword of the (33,2) code but rather a corrupted version of a legitimate codeword of the (33,8) code (because it is a concatenation of corrupted versions of legitimate (33,8) codewords), and would therefore be farther than T symbols from a legitimate C(33,2) codeword. The value T is chosen not as large as the number of symbols that can be corrected (judging from the minimum distance of the (33,2) code), but only as large as the number of symbols that might be corrected by the (33,8) code.

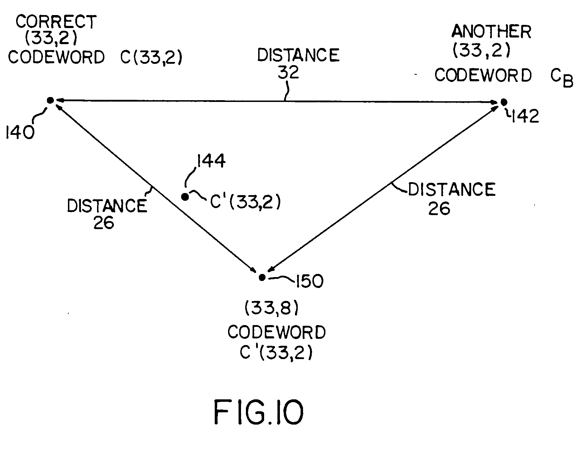

Referring to Fig. 10, the threshold T is chosen as follows. Suppose that the current sector is the one we are looking for, that is C'(33,2) is a corrupted version of a legitimate codeword C(33,2). Suppose, for example, that C'(33,2) lies at location 144 between two legitimate (33,2) codewords: the correct codeword C(33,2) (at location 140) and CB (at location 142). C(33,2) and CB are of course 32 apart so that C'(33,2) can be correctly decoded to C(33,2) provided there are no more than 15 erroneous symbols in C'(33,2). On the other hand, if the current sector is not the one being sought, then C'(33,2) will not be a corrupted version of a legitimate (33,2) codeword, but rather a corrupted version of a legitimate (33,8) codeword.

Suppose that there are no recording errors so that C'(33,2) is in fact a (33,8) codeword, for example the one labeled 150 in Fig. 10. Recall that (33,2) codewords 140, 142 are also (33,8) codewords (the (33,2) codewords are a subset of the (33,8) codewords). Thus codeword 150 is only 26 away from codewords 120, 122. Therefore a corrupted codeword C'(33,2) 144 which is in fact a corrupted version of a legitimate codeword C(33,8) 150 but is still less than 15 away from codeword 140 would mistakenly be decoded to codeword 140 as indicating that the desired sector had been found even though in fact codeword 144 is a corrupted version of the (33,8) codeword 150. In order to prevent this error, the threshold T is set at 12, the maximum number of errors correctable by the (33,8) code.

In summary, because (33,8) codewords are closer together than (33,2) codewords, when we attempt to determine whether a given corrupted codeword is a (33,2) codeword we may only base the decision on a threshold distance that is the same as the distance of the (33,8) code. Otherwise, we may erroneously decode the corrupted codeword to a (33,2) codeword when in fact it should be decoded to a (33,8) codeword.

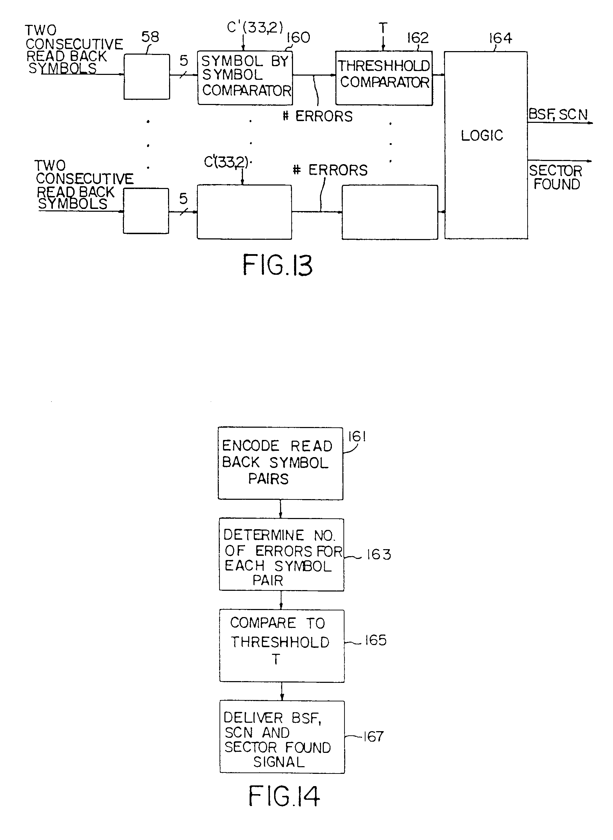

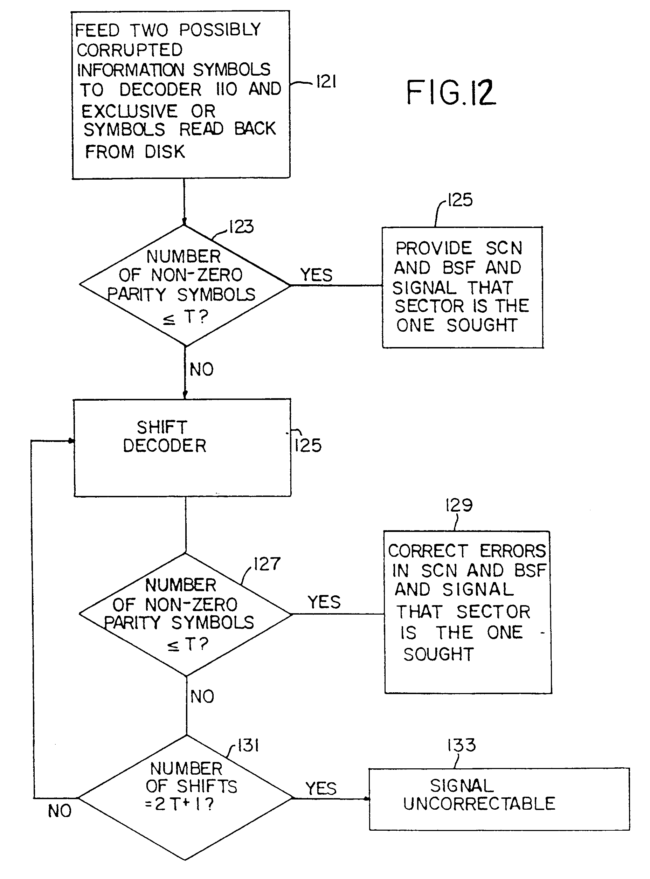

Referring to Figs. 11, 12, to accomplish the above procedure, C'(33,2) is decoded by a permutation decoder 110 which is like the encoder for the (33,2) code connected in accordance with the generator polynomial. The (33,2) code is completely decodable by permutation decoding. The goal of the permutation decoding is to find two correct adjacent symbols anywhere in the 33-symbol word. Decoder 110 is a linear feedback shift register of 31 delay elements 112 (numbered 30-i to 0-i respectively) with the delay elements separated by exclusive OR elements 114. The second input to each exclusive OR element is from an alpha block 116 which generates the product of the indicated alpha value times the value on line 118.

The left-most delay element feeds an exclusive OR element 120 whose other input is delivered on line 122. To begin decoding, the two high order symbols of C'(33,2) are fed (121) to input line 122. The alpha blocks 116 perform their multiplications and the results are exclusively ORed with the outputs of the respective delay elements (i.e., zero symbols); those results are stored in the next adjacent delay elements. The contents of the thirty-one delay elements represent the parity check symbols of the two symbols most recently fed in. The next step is to exclusively OR (in the exclusive OR elements 117) each of the 31 parity check symbols with the corresponding 31 parity check symbols in F'(33,8) retrieved from the disk. If there are no errors in F'(33,8) all of the 31 delay elements 112 will then contain zeros. If there are no more than T non-zero symbols in the 31 delay elements (123), then it is known (125) that the original two information symbols entered into the decoder were both correct and also that the C'(33,2) codeword is correctable within the required maximum T errors. The errors will be indicated by the non-zero symbols in the delay elements.

If the number of non-zero parity symbols in the delay elements exceeds the threshold T (indicating either that the two information symbols contain errors or that there are more than a correctable number of errors in the 31 parity symbols), the decoder is shifted (125) without entering any new symbols at input 122. After each even-numbered shift (i.e., shift 2, shift 4, ..., shift 2T), the number of non-zero parity symbols is counted. If T or fewer non-zero parity symbols appear in the delay elements after a given shift (127), the scn and bsf symbols are corrected and delivered along with a signal indicating that the desired sector has been found (129). Otherwise, once 2*T shifts have been completed (131) the system signals that the errors are uncorrectable (133). (Note that there are a total of 2*T additional shifts without feeding in the input symbols; but only T of these 2*T shifts require that the non-zero symbols in the delay elements be counted. If the original contents of the delay elements is considered as shift 0, there are a total of 2*T + 1 shifts, but only T + 1 of the shifts, the even-numbered shifts, are to be counted.)

The bsf and scn symbols are corrected in the following way. If at shift i the count of the non-zero parity symbols is T or less, then all of the errors are confined to symbols 30-i through symbol -i. (By adding 33 to a negative symbol number one can identify the symbol by a non-negative integer between 0 and 32). The parity symbols contain the pattern of the symbol errors and the errors can be corrected. For example, if the count of non-zero parity symbols is T or less for shift i = 4, then symbols 26, 25,...1, 0, -1,..., -4, i.e., symbols 26, 25,...1, 0, 33,..., 29, contain all of the errors.

In fact the only error patterns that need to be considered are those for symbols 32 and 31 (i.e., the two high order symbols corresponding to scn and bsf). The error patterns for those symbols are found by the following rule. If there are no more than T non-zero parity symbols at shift i then the error pattern for symbol 32 is symbol i-1 and the error pattern for symbol 31 is symbol i-2 of the delay elements. If i-1 is negative, then symbol 32 is error free.

Referring to Figs. 13, 14, alternatively, decoding may be accomplished using encoders configured according to the recursive polynomial as in Fig. 4. A dedicated encoder 58 is provided for encoding each one of 33 different pairs as a (33,2) codeword (161). Each of the 33 different pairs is one of the adjacent two symbols in the codeword C'(33,2). The qth encoded codeword is then compared to C'(33,2) in a comparator 160 to determine the number of symbol errors (163). The number of symbol errors is then compared (165) with the threshold T in a comparator 162. The outputs of all comparators 162 are connected to logic 164. If all of the outputs of comparators 162 indicate that the threshold has been exceeded then logic 164 signals that the errors are uncorrectable. Otherwise logic 164 signals that the desired sector has been found and delivers the values of bsf and scn corresponding to the possible symbol pair that produced the sufficiently low number of symbol errors (167).

During a startup mode, when the header address is usually not known in advance, in order to recover the bsf and scn symbols, the code must be decoded as a (33,8) code. Depending on the number of errors to be corrected, there are several possible approaches.

For correcting three symbol errors, the first 32 symbols are divided into four sets of eight symbols each. With no more than three symbol errors this guarantees that at least one of the eight-symbol sets is error free. The permutation decoding is done by finding the error-free symbol set using an encoder configured either serially in accordance with G8(X) or in parallel (as in Fig. 13) in accordance with the recursive polynomial H8(X). Once found, all errors in the thirty-three symbol word can be corrected.

For correcting four symbol errors, one could take the approach of multiple parallel permutation decoders each applied to one of the possible eight consecutive symbol strings, but the added complexity would only be able to correct one additional error. Even more complexity would be required for decoding 5, 6, 7, 8, 9, 10, 11 or 12 errors.

A full decoder for correcting twelve errors is also possible. The decoding is done over $GF(2^{10})$ rather than over $GF(2^5)$.

Additional discussion of (33,K) codes may be found at Section 5, chapter 11 of MacWilliams and Sloane, <u>The Theory of</u> <u>Error-Correcting Codes</u> (North-Holland, New York, 1977).

### Claims

1. A method for determining whether particular information was used in encoding a previously encoded codeword (F'(33,8)) which was formed by encoding information (32) as a first preliminary code sequence (40) in accordance with a first code, and combining said first preliminary code sequence with a second preliminary code sequence (42) generated in accordance with a second code, characterized in that said previously encoded codeword is decoded by

   encoding said particular information as a particular first preliminary code sequence (C'(33,8)) in accordance with said first code,

   stripping said particular first preliminary code sequence from said previously encoded codeword, by performing an Exclusive OR operation between them, to derive a test sequence which is different from said previously encoded codeword or any fragment thereof,

   decoding said test sequence in accordance with said second code, and

   determining, based on an error evaluation following said decoding, whether said particular information was used in encoding said previously encoded codeword.

2. The method of claim 1 wherein the legitimate code sequences of said second code are a subset of the legitimate code sequences of said first code.

3. The method of claim 1 wherein said previously encoded codeword is a legitimate code sequence of said first code.

4. The method of claim 1 wherein said first code is not systematic with respect to said piece of information.

5. The method of claim 1 wherein said first code is a cyclic error correcting (n,k) code and said second code is a cyclic error correcting (n,m) code where m is smaller than k.

6. The method of claim 1 wherein said second code is susceptible to being fully decoded by permutation decoding but said first code is not susceptible to being fully decoded by permutation decoding.

7. The method of claim 1 wherein said first and second codes comprise Reed-Solomon codes.

8. The method of claim 1 said first code is rate (33,8) code and said second code is a (33,2) code.

EP 0 365 634 B1

9. The method of claim 1 further adapted for encoding additional information in said previously encoded codeword, and wherein, without fully decoding a potentially corrupted version of said previously encoded codeword, said additional information may be fully reconstructed from said corrupted codeword, comprising

encoding said additional information in said second preliminary code sequence, and

reconstructing said additional information based on said decoding.

10. The method of claim 1 wherein said information comprises an address (32) of a block of data on a recording medium.

11. The method of claim 10 wherein said block comprises a sector (12) of a magnetic disk.

12. The method of claim 9 wherein said additional information comprises a bad sector flag (BSF) for a magnetic disk.

13. The method of claim 9 wherein said additional information comprises a servo correction number (SCN) for a magnetic disk.

14. The method of claim 1 further comprising

combining said first preliminary code sequence and said second preliminary code sequence with a coset leader (54) to form said previously encoded codeword, and

removing said coset leader from a potentially corrupted version of said previously encoded codeword prior to said stripping of said first preliminary code sequence.

15. The method of claim 9 wherein said second code is systematic with respect to said additional information.

16. The method of claim 9 wherein said previously encoded codeword comprises a string of n symbols, the high order m said symbols being said additional information.

17. The method of claim 1 wherein said first preliminary code sequence comprises a string of A symbols, the high order k said symbols comprising at least one zero symbol followed by said information.

18. The method of claim 1 wherein said decoding comprises permutation decoding over a field of finite elements having fewer elements than the field that would be required for fully decoding said corrupted codeword.

19. The method of claim 1 wherein said determining comprises detecting the distance between said test sequence and legitimate code sequences of said second code.

20. The method of claim 19 wherein said determining further comprises comparing said distance with a predetermined threshold value.

21. The method of claim 20 wherein said predetermined threshold has a maximum value that is smaller than the error correcting capability of said second code.

22. The method of claim 21 wherein said predetermined threshold is the same as the error correcting capability of said first code.

23. The method of claim 1 wherein said first and second codes comprise maximum distance separable codes, said first code having a smaller distance than said second code.

24. The method of claim 9 wherein said decoding comprises

encoding simultaneously in parallel in accordance with said second code possible code sequences corresponding to each possible value of said additional information, and

comparing simultaneously in parallel each possible code sequence with said test sequence.

10

EP 0 365 634 B1

**25.** Apparatus for determining whether particular information was used in encoding a previously encoded codeword (F'(33,8)) which was formed by encoding information (32) as a first preliminary code sequence (40) in accordance with a first code, and combining said first preliminary code sequence (40) with a second preliminary code sequence (42) generated in accordance with a second code, characterized in that said apparatus comprises

an encoder for encoding said particular information as a particular first preliminary code sequence (C'(33,8)) in accordance with said first code,

a decoder comprising

(i) means for stripping said particular first preliminary code sequence from said previously encoded codeword, by performing an Exclusive OR operation between them, to derive a test sequence which is different from said previously encoded codeword or any fragment thereof,

(ii) means for decoding said test sequence in accordance with said second code, and

(iii) means for determining, based on an error evaluation following said decoding, whether said particular information was used in encoding said previously encoded codeword.

**26.** The method of claim 1 further adapted for locating a sector (12) on a magnetic disk, wherein the address (32) of said sector is encoded in said first preliminary code sequence, further comprising

recording said previously encoded codeword in said sector during formatting of said magnetic disk,

reading said previously encoded codeword, possibly corrupted, from said sector rotating under a head,

encoding the desired address in said particular first preliminary code sequence,

comparing the number of errors in said test sequence to a threshold T, and

if the number of errors is no greater than T, accepting the sector as the one being sought, otherwise proceeding to the next sector.

**27.** The method of claim 1 further adapted for locating an unwritable sector (12) on a magnetic disk during a write operation, wherein the address (32) of said sector is encoded in said first preliminary code sequence, and bad sector and servo control information (30) are encoded in said second preliminary code sequence, further comprising

recording said previously encoded codeword in said sector during formatting of said magnetic disk,

reading said previously encoded codeword, possibly corrupted, from said sector rotating under a head,

comparing the number of errors in said test sequence to a threshold T, and

if the number of errors is no greater than T, accepting the decoded bad sector information and using the decoded servo control information to control the position of said head, otherwise not.

**28.** The method of claim 1 further adapted for centering a head on a track of a magnetic disk, wherein the address (32) of a sector (12) is encoded in said first preliminary code sequence, and bad sector and servo control information (30) are encoded in said second preliminary code sequence, further comprising

recording said previously encoded codeword in said sector during formatting of said magnetic disk,

reading said previously encoded codeword, possibly corrupted, from said sector rotating under said head,

comparing the number of errors in said test sequence to a threshold T, and

if the number of errors is no greater than T, using said servo control information to control the location of said head.

**Patentansprüche**

**1.** Ein Verfahren zum Bestimmen, ob eine besondere Information benutzt wurde beim Codieren eines zuvor codierten Codewortes (F'(33,8)), das gebildet wurde durch die Codierung einer Information (32) als eine erste vorläufige Codesequenz (40) in Übereinstimmung mit einem ersten Code und durch das Kombinieren der ersten vorläufigen Codesequenz mit einer zweiten vorläufigen Codesequenz (42), die in Übereinstimmung mit einem zweiten Code erzeugt wurde, dadurch gekennzeichnet, daß das zuvor codierte Codewort decodiert wird durch

Codierung der besonderen Information als eine besondere erste vorläufige Codesequenz (C'(33,8)) in Übereinstimmung mit dem ersten Code,

Abspalten des besonderen ersten vorläufigen Codes von dem zuvor codierten Codewort, indem

11

eine Exklusiv-ODER-Operation zwischen ihnen ausgeführt wird, um eine Testsequenz abzuleiten, die von dem zuvor codierten Codewort oder irgendeinem Fragment davon verschieden ist,

Decodieren der Testsequenz in Übereinstimmung mit dem zweiten Code und

Bestimmen, basierend auf einer der Decodierung folgenden Fehlerauswertung, ob die besondere Information beim Codieren des zuvor codierten Codewortes benutzt worden ist.

2. Verfahren nach Anspruch 1, bei dem die legitimen Codesequenzen des zweiten Codes eine Untermenge der legitimen Codesequenzen des ersten Codes sind.

3. Verfahren nach Anspruch 1, bei dem das zuvor codierte Codewort eine legitime Codesequenz des ersten Codes ist.

4. Verfahren nach Anspruch 1, bei dem der erste Code nicht systematisch bezüglich dieses Stückes der Information ist.

5. Verfahren nach Anspruch 1, bei dem der erste Code ein zyklischer, fehlerkorrigierender (n,k) Code und der zweite Code ein zyklischer, fehlerkorrigierender (n,m) Code ist, wobei m kleiner als k ist.

6. Verfahren nach Anspruch 1, bei dem der zweite Code durch Permutations-Decodierung vollständig decodiert werden kann, der erste Code durch Permutations-Decodierung aber nicht vollständig decodiert werden kann.

7. Verfahren nach Anspruch 1, bei dem die ersten und zweiten Codes Reed-Solomon-Codes beinhalten.

8. Verfahren nach Anspruch 1, bei dem der erste Code ein Rang-(33,8)-Code und der zweite Code ein Rang-(33,2)-Code ist.

9. Verfahren nach Anspruch 1, das weiterhin eine zusätzliche Information in dem zuvor codierten Codewort codieren kann, wobei, ohne eine möglicherweise verfälschte Version des zuvor codierten Codewortes vollständig zu decodieren, die zusätzliche Information vollständig aus dem verfälschten Codewort rekonstruiert werden kann, wobei es umfaßt

Codierung der zusätzlichen Information in der zweiten vorläufigen Codesequenz und

Rekonstruieren der zusätzlichen Information basierend auf der Decodierung.

10. Verfahren nach Anspruch 1, bei dem die Information eine Adresse (32) eines Datenblocks auf dem Aufzeichnungs-Medium enthält.

11. Verfahren nach Anspruch 10, bei dem der Block einen Sektor (12) einer Magnetplatte aufweist.

12. Verfahren nach Anspruch 9, bei dem die zusätzliche Information eine Anzeige "fehlerhafter Sektor" (BSF = bad sector flag) für eine Magnetplatte enthält.

13. Verfahren nach Anspruch 9, bei dem die zusätzliche Information eine "Servo-Korrektur-Zahl" (SCN = servo correction number) für eine Magnetplatte enthält.

14. Verfahren nach Anspruch 1, das weiterhin aufweist

Kombinieren der ersten vorläufigen Codesequenz und der zweiten vorläufigen Codesequenz mit dem Leitelement (54) eines Cosets, um das zuvor codierte Codewort zu bilden und

Entfernen des Leitelements des Cosets von einer möglicherweise verfälschten Version des zuvor codierten Codewortes vor dem Abspalten der ersten vorläufigen Codesequenz.

15. Verfahren nach Anspruch 9, bei dem der zweite Code bezüglich der zusätzlichen Information systematisch ist.

16. Verfahren nach Anspruch 9, bei dem das zuvor codierte Codewort einen String von n Symbolen enthält, wobei die höherwertigen m Symbole die zusätzliche Information darstellen.

**17.** Verfahren nach Anspruch 1, bei dem die erste vorläufige Codesequenz einen String von A Symbolen enthält, wobei die höherwertigen k Symbole mindestens ein Null-Symbol enthalten, das von der Information gefolgt wird.

**18.** Verfahren nach Anspruch 1, bei dem die Decodierung eine Permutations-Decodierung über ein Feld finiter Elemente enthält, wobei dieses Feld weniger Elemente hat als das Feld, das für das vollständige Decodieren des verfälschten Codewortes benötigt werden würde.

**19.** Verfahren nach Anspruch 1, bei dem das Bestimmen das Feststellen der Distanz zwischen der Testsequenz und den legitimen Codesequenzen des zweiten Codes umfaßt.

**20.** Verfahren nach Anspruch 19, bei dem das Bestimmen weiterhin den Vergleich der Distanz mit einem vorher festgelegten Schwellwert enthält.

**21.** Verfahren nach Anspruch 20, bei dem der vorher festgelegte Schwellwert einen Maximalwert hat, der kleiner ist als die Fehlerkorrekturfähigkeit des zweiten Codes.

**22.** Verfahren nach Anspruch 21, bei dem der vorher festgelegte Schwellwert gleich der Fehlerkorrekturfähigkeit des ersten Codes ist.

**23.** Verfahren nach Anspruch 1, bei dem der erste und zweite Code durch eine maximale Distanz unterscheidbare Codes enthalten, wobei der erste Code eine kleinere Distanz als der zweite Code hat.

**24.** Verfahren nach Anspruch 9, bei dem die Decodierung aufweist
   simultanes, paralleles Codieren, in Übereinstimmung mit dem zweiten Code, von möglichen Codesequenzen entsprechend jedem möglichen Wert der zusätzlichen Information und
   simultanes, paralleles Vergleichen jeder möglichen Codesequenz mit der Testsequenz.

**25.** Vorrichtung zum Bestimmen, ob eine besondere Information benutzt wurde beim Codieren eines zuvor codierten Codewortes (F'(33,8)), das gebildet wurde durch die Codierung einer Information (32) als eine erste vorläufige Codesequenz (40) in Übereinstimmung mit einem ersten Code und das Kombinieren der ersten vorläufigen Codesequenz (40) mit einer zweiten vorläufigen Codesequenz (42), die in Übereinstimmung mit einem zweiten Code erzeugt wurde, dadurch gekennzeichnet, daß die Vorrichtung aufweist
   einen Codierer zum Codieren der besonderen Information als eine besondere erste vorläufige Codesequenz (C'(33,8))in Übereinstimmung mit dem ersten Code,
   einen Decodierer, der seinerseits aufweist
   (i) Eine Einrichtung zum Abspalten der besonderen ersten vorläufigen Codesequenz von dem zuvor codierten Codewort durch das Ausführen einer Exklusiv-ODER-Operation zwischen ihnen, um eine Testsequenz abzuleiten, die von dem zuvor codierten Codewort oder irgend einem Fragment davon verschieden ist,
   (ii) Eine Einrichtung zum Decodieren der Testsequenz in Übereinstimmung mit dem zweiten Code und
   (iii) Eine Einrichtung zum Bestimmen, basierend auf einer der Decodierung folgenden Fehlerauswertung, ob die besondere Information beim Codieren des zuvor codierten Codewortes benutzt wurde.

**26.** Verfahren nach Anspruch 1, das weiterhin zur Lokalisierung eines Sektors (12) einer Magnetplatte geeignet ist, wobei die Adresse (32) des Sektors codiert ist in der ersten vorläufigen Codesequenz, wobei es weiterhin die Schritte aufweist
   Aufzeichnen des zuvor codierten Codewortes in diesem Sektor während der Formatierung der Magnetplatte,
   Lesen des zuvor codierten, möglicherweise verfälschten Codewortes aus dem gerade unter einem Kopf vorbeidrehenden Sektor,
   Codieren der gewünschten Adresse in der besonderen ersten vorläufigen Codesequenz,
   Vergleichen der Anzahl von Fehlern in der Testsequenz mit einem Schwellwert T und
   Akzeptieren des Sektors als den gesuchten, wenn die Anzahl von Fehlern nicht größer als T ist, andernfalls Fortschreiten zum nächsten Sektor.

**27.** Verfahren nach Anspruch 1, das weiterhin zur Lokalisierung eines nicht-beschreibbaren Sektors (12) auf einer Magnetplatte während einer Schreiboperation geeignet ist, wobei die Adresse (32) dieses Sektors in der ersten vorläufigen Codesequenz codiert ist und die Information (30) über einen fehlerhaften Sektor und Servo-Steuerung in einer zweiten vorläufigen Codesequenz codiert sind und weiterhin umfaßt

Aufzeichnen des vorläufig codierten Codewortes in diesem Sektor während der Formatierung der Magnetplatte,

Lesen des vorläufig codierten, möglicherweise verfälschten Codewortes aus dem gerade unter einem Kopf vorbeidrehenden Sektor,

Vergleichen der Anzahl von Fehlern in der Testsequenz mit einem Schwellwert T und

Akzeptieren der decodierten Information über einen fehlerhaften Sektor und das Benutzen der Servo-Steuer-Information zum Steuern besagter Kopfposition, wenn die Anzahl von Fehlern nicht größer als T ist, andernfalls nicht.

**28.** Verfahren nach Anspruch 1, das weiterhin zum Zentrieren eines Kopfes auf einer Spur einer Magnetplatte geeignet ist, wobei die Adresse (32) eines Sektors (12) codiert ist in der ersten vorläufigen Codesequenz und die Information über fehlerhafte Sektoren und Servo-Steuerung (30) codiert sind in der zweiten vorläufigen Codesequenz, wobei es weiterhin die Schritte aufweist

Aufzeichnen des vorläufig codierten Codewortes in diesem Sektor während der Formatierung der Magnetplatte,

Lesen des vorläufig codierten, möglicherweise verfälschten Codewortes aus dem gerade unter einem Kopf vorbeidrehenden Sektor,

Vergleichen der Anzahl von Fehlern in der Testsequenz mit einem Schwellwert T und

Benutzen der Steuer-Information zum Steuern der Kopflage, wenn die Anzahl von Fehlern nicht größer als T ist.

## Revendications

**1.** Procédé servant à déterminer si des informations particulières ont été utilisées lors du codage d'un mot de code codé précédemment (F'(33,8)) qui a été formé en codant des informations (32) en tant que première séquence de code préliminaire (40) conformément à un premier code, et en combinant ladite première séquence de code préliminaire avec une seconde séquence de code préliminaire (42) générée conformément à un second code, caractérisé en ce que ledit mot de code codé précédemment est décodé en:

codant lesdites informations particulières en tant que première séquence de code préliminaire particulière (C'(33,8)) conformément audit premier code,

retirant dudit mot de code codé précédemment ladite première séquence de code préliminaire particulière en exécutant entre eux une opération OU exclusif, pour obtenir une séquence d'essai qui est différente dudit mot de code codé précédemment ou d'un fragment quelconque de ce dernier,

décodant ladite séquence d'essai conformément audit second code, et

déterminant, sur la base d'une évaluation d'erreurs suivant ledit décodage, si lesdites informations particulières ont été utilisées lors du codage dudit mot de code codé précédemment.

**2.** Procédé selon la revendication 1, dans lequel les séquences de code légitimes dudit second code constituent un sous-ensemble des séquences de code légitimes dudit premier code.

**3.** Procédé selon la revendication 1, dans lequel ledit mot de code codé précédemment est une séquence de code légitime dudit premier code.

**4.** Procédé selon la revendication 1, dans lequel ledit premier code n'est pas systématique par rapport auxdites informations particulières.

**5.** Procédé selon la revendication 1, dans lequel ledit premier code est un code (n, k) de correction d'erreur cyclique et ledit second code est un code (n,m) de correction d'erreur cyclique où m est inférieur à k.

**6.** Procédé selon la revendication 1, dans lequel ledit second code est susceptible d'être décodé intégralement par décodage à permutation mais ledit premier code n'est pas susceptible d'être décodé

14

intégralement par décodage à permutation.

7. Procédé selon la revendication 1, dans lequel lesdits premier et second codes sont des codes Reed-Solomon.

8. Procédé selon la revendication 1 dans lequel ledit premier code est un code (33,8) et ledit second code est un code (33,2).

9. Procédé selon la revendication 1, adapté en outre pour le codage d'informations additionnelles dans ledit mot de code codé précédemment et dans lequel, sans le décodage intégral d'une version éventuellement altérée dudit mot de code codé précédemment, lesdites informations additionnelles peuvent être reconstruites intégralement à partir dudit mot de code altéré, consistant:
à coder lesdites informations additionnelles dans ladite seconde séquence de code préliminaire, et
a reconstruire lesdites informations additionnelles sur la base dudit décodage.

10. Procédé selon la revendication 1, dans lequel lesdites informations comportent une adresse (32) d'un bloc de données se trouvant sur un support d'enregistrement.

11. Procédé selon la revendication 10, dans lequel ledit bloc comporte un secteur (12) d'un disque magnétique.

12. Procédé selon la revendication 9, dans lequel lesdites informations additionnelles comportent un drapeau de secteur défectueux (BSF) pour disque magnétique.

13. Procédé selon la revendication 9, dans lequel lesdites informations additionnelles comportent un numéro de correction asservie (SCN) pour disque magnétique.

14. Procédé selon la revendication 1, consistant en outre:
à combiner ladite première séquence de code préliminaire et ladite seconde séquence de code préliminaire avec un caractère initial co-établi (54) pour former ledit mot de code codé précédemment, et
éliminer ledit caractère initial co-établi d'une version éventuellement altérée dudit mot de code codé précédemment avant ledit retrait de ladite première séquence de code préliminaire.

15. Procédé selon la revendication 9, dans lequel ledit second code est systématique par rapport auxdites informations additionnelles.

16. Procédé selon la revendication 9, dans lequel ledit mot de code codé précédemment comporte une chaîne de n symboles, les m symboles de poids fort parmi lesdits symboles constituant lesdites informations additionnelles.

17. Procédé selon la revendication 1, dans lequel ladite séquence de code préliminaire comporte une chaîne de A symboles, les k symboles de poids fort parmi lesdits symboles comportant au moins un symbole zéro suivi desdites informations.

18. Procédé selon la revendication 1, dans lequel ledit décodage comporte le décodage à permutation sur un champ d'éléments finis comportant moins d'éléments que le champ qui serait requis pour le décodage intégral dudit mot de code altéré.

19. Procédé selon la revendication 1, dans lequel ladite détermination consiste à détecter la distance séparant ladite séquence d'essai et des séquences de code légitimes dudit second code.

20. Procédé selon la revendication 19, dans lequel ladite détermination comporte en outre la comparaison entre ladite distance et une valeur de seuil prédéterminée.

21. Procédé selon la revendication 20, dans lequel ledit seuil prédéterminé a une valeur maximale qui est inférieure à la capacité de correction d'erreurs dudit second code.

**22.** Procédé selon la revendication 21, dans lequel ledit seuil prédéterminé est le même que la capacité de correction d'erreurs dudit premier code.

**23.** Procédé selon la revendication 1, dans lequel lesdits premier et second codes constituent des codes à distance maximale de séparation, ledit premier code présentant une distance inférieure à celle dudit second code.

**24.** Procédé selon la revendication 9, dans lequel ledit décodage consiste:

à coder simultanément en parallèle, conformément audit second code, des séquences de code possibles correspondant à chaque valeur possible desdites informations additionnelles, et

à comparer simultanément en parallèle chaque séquence de code possible à ladite séquence d'essai.

**25.** Appareil pour déterminer si des informations particulières ont été utilisées lors du codage d'un mot de code codé précédemment (F'(33,8)) qui a été formé en codant des informations (32) en tant que première séquence de code préliminaire (40) conformément à un premier code, et en combinant ladite première séquence de code préliminaire avec une seconde séquence de code préliminaire (42) générée conformément à un second code, caractérisé en ce que ledit appareil comporte:

un codeur pour coder lesdites informations particulières en tant que première séquence de code préliminaire particulière (C'(33,8)) conformément audit premier code,

un décodeur comportant:

(i) des moyens pour retirer dudit mot de code codé précédemment ladite première séquence de code préliminaire particulière en exécutant entre eux une opération OU exclusif pour obtenir une séquence d'essai qui diffère dudit mot de code codé précédemment ou d'un fragment quelconque de ce dernier,

(ii) des moyens pour décoder ladite séquence d'essai conformément audit second code, et

(iii) des moyens pour déterminer, sur la base d'une évaluation d'erreurs suivant ledit décodage, si lesdits informations particulières ont été utilisées lors du codage dudit mot de code codé précédemment.

**26.** Procédé selon la revendication 1, adapté en outre pour localiser un secteur (12) d'un disque magnétique, dans lequel l'adresse (32) dudit secteur est codé lors de ladite première séquence de code préliminaire, consistant en outre:

à enregistrer ledit mot de code codé précédemment dans ledit secteur au cours du formatage dudit disque magnétique,

à extraire ledit mot de code codé précédemment, éventuellement altéré, dudit secteur tournant sous une tête,

à coder l'adresse souhaitée dans ladite première séquence de code préliminaire particulière,

à comparer le nombre d'erreurs de la dite séquence d'essai à un seuil T, et

si le nombre d'erreurs n'est pas supérieur à T, à accepter le secteur en tant que secteur recherché, sinon à passer au secteur suivant.

**27.** Procédé selon la revendication 1, adapté en outre pour localiser un secteur inutilisable en écriture (12) sur un disque magnétique lors d'une opération d'écriture, dans lequel l'adresse (32) dudit secteur est codée dans ladite première séquence de code préliminaire, et des informations (30) de commande asservie et de secteur défectueux sont codées dans ladite seconde séquence de code préliminaire , consistant en outre:

à enregistrer ledit mot de code codé précédemment dans ledit secteur au cours du formatage dudit disque magnétique,

à extraire ledit mot de code codé précédemment, éventuellement altéré, dudit secteur tournant sous une tête,

à comparer le nombre d'erreurs de ladite séquence d'essai à un seuil T, et

si le nombre d'erreurs n'est pas supérieur à T, à accepter les informations de secteur défectueux décodées et à utiliser les informations de commande asservie décodées pour commander la position de ladite tête, autrement non.

**28.** Procédé selon la revendication 1, adapté en outre pour centrer une tête sur une piste d'un disque magnétique, dans lequel l'adresse (32) d'un secteur (12) est codée dans ladite première séquence de code préliminaire, et des informations (30) de commande asservie et de secteur défectueux sont codées dans ladite seconde séquence de code préliminaire, consistant en outre:

à enregistrer ledit mot de code codé précédemment dans ledit secteur lors du formatage dudit disque magnétique,

à extraire ledit mot de code codé précédemment, éventuellement altéré, dudit secteur tournant sous ladite tête,

à comparer le nombre d'erreurs de ladite séquence d'essai à un seuil T, et

si le nombre d'erreurs n'est pas supérieur à T, à utiliser lesdites informations de commande asservie pour commander l'emplacement de ladite tête.

FIG.1

FIG.2

EXPRESS BSF AND
SCN AS A PAIR
OF SYMBOLS   ~29

EXPRESS ADDRESS
AS A STRING OF
SIX SYMBOLS   ~31

ENCODE BSF/SCN
AS C(33,2)
CODEWORD   ~33

ENCODE ADDRESS
AS C(33,8)
CODEWORD   ~35

EXCLUSIVELY OR
C(33,2) AND C(33,8)
TO GET F(33,8)   ~37

EXCLUSIVELY
OR F(33,8)
WITH COSET
LEADER TO
FORM G(33,8)   ~39

FIG.3

58

64

5

EXCLUSIVE
OR

5                              66            5

60      ALPHA 7    62

D                 D

61                5              5

BSF           SCN

OUTPUT

FIG.4

FIG.5

FIG.6

C'(33,8) | O O | M N P Q R S | | . . . |

F'(33,8) | | | | . . . |

C'(33,2) | | | | . . . |

## FIG.7

```
┌─────────────────┐
│ ENCODE DESIRED  │
│ ADDRESS  AS     │──~90
│ C'(33,8)        │
└─────────────────┘
         │
         ▼
┌─────────────────┐
│   C'(33,8)      │
│     (+)         │──~92
│   F'(33,8)      │
└─────────────────┘
         │
         ▼
┌─────────────────┐
│    DECODE       │
│    C'(33,2)     │──~94
└─────────────────┘
         │
         ▼
      ◇ 96                    ┌──────────────┐ ~100
     NUMBER                   │  DECLARE     │
     ERRORS    ──────────────▶│  ERRORS      │
      ≤ T?                    │  NOT         │
                             │  CORRECTABLE  │
         │                    └──────────────┘
         ▼
┌─────────────────┐
│    SIGNAL       │
│    HEADER       │──~98
│    ADDRESS      │         FIG.8
│    CORRECT      │
└─────────────────┘
         │
         ▼
┌─────────────────┐
│   DELIVER       │
│   DECODED       │──~102
│   BSF/SCN       │
└─────────────────┘
```

G'(33,8)

COSET
LEADER ──→(+)─┐91

DESIRED
ADDRESS ──→ │ 57 │          F'(33,8)          │ 95 │
            │(33,8)│ C'(33,8)         │PERMUTATION│ BSF/SCN SYMBOLS ──→
   00   ──→ │ENCODER│──→(+)─ C'(33,2) ─→│ DECODER │
            └──────┘    93              └────────┘
                                            │ NO. OF
                                            │ ERRORS
                                            ↓
## FIG.9
                              T ──→│COMPARE│──→ SIGNAL
                                   └──────┘    WHETHER
                                      97       HEADER
                                               ADDRESS IS
                                               CORRECT

118

┌─ALPHA 7─┐ ┌─ALPHA 27─┐  . . .  ┌─ALPHA 27─┐ ┌─ALPHA 7─┐ 116

120                                                      114    112
(+)──D──(+)──D──(+)── . . . ──(+)──D──(+)──D──(+)
    30-i    29-i            1-i      0-i

122
   5
INPUT                    SYMBOLS
                         READ BACK
                         FROM DISK
        110
## FIG.II

22

CORRECT
(33,2)
CODEWORD C(33,2)

DISTANCE
32

ANOTHER
(33,2)
CODEWORD $C_B$

140

142

144

C'(33,2)

DISTANCE
26

DISTANCE
26

150

(33,8)
CODEWORD
C'(33,2)

FIG.10

TWO
CONSECUTIVE
READ BACK
SYMBOLS
58
5

C'(33,2)
160
SYMBOL BY
SYMBOL
COMPARATOR

T
162
THRESHHOLD
COMPARATOR

164

# ERRORS

LOGIC

BSF, SCN

SECTOR
FOUND

TWO
CONSECUTIVE
READ BACK
SYMBOLS
5

C'(33,2)·

# ERRORS

FIG.13

ENCODE READ
BACK SYMBOL
PAIRS
161

DETERMINE NO.
OF ERRORS FOR
EACH SYMBOL
PAIR
163

COMPARE TO
THRESHHOLD
T
165

DELIVER BSF,
SCN AND
SECTOR FOUND
SIGNAL
167

FIG.14

FIG.12

```
┌─────────────────────┐
│ FEED TWO POSSIBLY    │
│ CORRUPTED            │
│ INFORMATION SYMBOLS  │──── 121
│ TO  DECODER  110 AND │
│ EXCLUSIVE  OR        │
│ SYMBOLS  READ  BACK  │
│ FROM  DISK           │
└─────────────────────┘
           │
           ▼
      ╱─────────╲          123                ┌──────────────────┐  125
     ╱  NUMBER   ╲                            │ PROVIDE  SCN     │
    ╱ OF NON-ZERO ╲          YES              │ AND  BSF AND     │
    ╲ PARITY SYMBOLS╱ ─────────────────────── │ SIGNAL  THAT     │
     ╲    ≤ T?    ╱                           │ SECTOR  IS THE   │
      ╲─────────╱                             │ ONE  SOUGHT      │
           │                                  └──────────────────┘
           │ NO
           ▼
     ┌──────────────┐
     │   SHIFT      │
     │  DECODER     │──── 125
     └──────────────┘
           │
           ▼
      ╱─────────╲          127                ┌──────────────────┐  129
     ╱  NUMBER   ╲                            │ CORRECT  ERRORS  │
    ╱ OF NON-ZERO ╲          YES              │ IN SCN AND BSF   │
    ╲ PARITY SYMBOLS╱ ─────────────────────── │ AND  SIGNAL      │
     ╲    ≤ T?    ╱                           │ THAT  SECTOR     │
      ╲─────────╱                             │ IS  THE  ONE     │
           │                                  │ SOUGHT           │
           │ NO                               └──────────────────┘
           ▼
      ╱─────────╲          131                ┌──────────────────┐  133
     ╱  NUMBER   ╲          YES               │   SIGNAL         │
    ╱ OF SHIFTS   ╲ ─────────────────────────│ UNCORRECTABLE    │
    ╲  =2 T+1 ?   ╱                           └──────────────────┘
     ╲─────────╱
     NO
```